# EUROPÄISCHE PATENTANMELDUNG

(11) **EP 1 662 569 A1**
(43) Veröffentlichungstag der Anmeldung: **31.05.2006**
(21) Anmeldenummer: 04771939.8
(22) Anmeldetag: 20.08.2004
(51) Int. Cl.: H01L 27/04, G01R 31/28

(54) **SCHALTUNG ZUM FESTSTELLEN UND MESSEN VON GERÄUSCHEN IN INTEGRIERTEN HALBLEITERSCHALTUNGEN**

(30) Priorität: 22.08.2003 JP 2003298080
(71) Anmelder: The New Industry Research Organization, Kobe-shi, Hyogo 650-0047 (JP)
(72) Erfinder: Nagata, Makoto, Kobe-shi, Hyogo 6570059 (JP)
(74) Vertreter: Jeck, Anton
(86) Internationale Anmeldenummer: PCT/JP2004/011978
(87) Internationale Veröffentlichungsnummer: WO 2005/020324

(57) **Zusammenfassung**

Eine Geräuschmessschaltung und eine Geräuschmessschaltung gemäß der vorliegenden Erfindung können Stromversorgungs-Geräuschwellenformen, Massepegel-Geräuschwellenformen und eine räumliche Verteilung der Geräusch aufweisenden Positionen durch Einbetten der Geräuschmessschaltungen in eine Anordnung verteilter Positionen in einer integrierten Halbleiterschaltung feststellen, die eine Vielzahl von Schaltungsblöcken zur Durchführung einer digitalen Signalverarbeitung aufweist. Die Geräuschmessschaltung und die Geräuschmessschaltung werden durch ein Herstellungsverfahren gefertigt, das für die integrierte CMOS-Halbleiterschaltung vorgesehen ist. Die Stromversorgungs-Geräuschmessschaltung und die Massepegel-Geräuschmessschaltung weisen jeweils einen Sourceelektrodenfolger, einen Auswählausleseschalter und einen mit seiner Sourceelektrode auf Masse gelegten Verstärker auf. Diese Geräuschmessschaltungen können mit nur einigen (etwa 6) MOS-Transistoren aufgebaut werden, so dass die Geräuschmessschaltung klein und in derselben Größe wie die Standardzelltyplogiktorschaltung ausgebildet werden kann. Was das Ausgangssignal der Geräuschmessschaltungen betrifft, so wird der Ausgangsstrom des mit seiner Sourceelektrode auf Masse gelegten Verstärkers einer Strombusleitung zugeführt; der Ausgangsstrom wird verstärkt, und der verstärkte Strom wird durch Betreiben einer externen Widerstandslastschaltung gelesen. Eine Vielzahl von Geräuschmessschaltungen können parallel zur Strombusleitung geschaltet sein, und eine Vielfachstellen-Geräuschmessung in der integrierten Hauptschaltung kann durch Auslesen des Ausgangsstroms erreicht werden.

## Beschreibung

Die vorliegende Erfindung betrifft eine Geräuschmessschaltung zum Feststellen und Messen von Geräuschen, die im Stomversorgungssignal oder Massepegelsignal hochintegrierter Schaltungen vorhanden sind.

Aufgrund des Fortschritts bei der Entwicklung von hochintegrierten Festkörperschaltungen, die von der Entwicklung der Mikroherstellungstechnologie beim Halbleiterherstellungsprozess begleitet ist, können Spannungsschwankungen im Stromversorgungssignal oder im Massepegelsignal auftreten, wenn die integrierte Schaltung aktiviert ist. Diese Spannungsschwankungen beeinträchtigen die Zuverlässigkeit des Betriebs der integrierten Schaltung. Mit einem Blick auf die Lösung des oben erwähnten Problems, um eine Betriebsstörung zu analysieren, die einen Fehler in der integrierten Schaltung verursacht, ist unbedingt ein Auswerteverfahren zur Auswertung der Spannungsschwankung des Stromversorgungssignals oder des Massepegelsignals erforderlich; kurz gesagt, ist ein Geräuschauswerteverfahren unbedingt erforderlich.

Üblicherweise ist die Verwendung eines Geräuschauswerteverfahrens hauptsächlich durch den Forschungszweck begrenzt. Viele Forschungen sind auf die Entwicklung von den bestimmten Zweck erfüllende Testchips gerichtet, in denen sowohl die hochintegrierte Hauptschaltung (die die Geräuschquelle bildet) als auch die Geräuschmessschaltung eingebettet sind. Die bekannte Geräuschmessschaltung ist jedoch im Chip getrennt von der hochintegrierten Hauptschaltung (die die Geräuschquelle bildet) angeordnet, und deshalb ist es schwierig, die bekannte Geräuschmessschaltung als praktisch zu gebrauchende Fehleranalyseschaltung im kommerziellen, hochintegrierten Basisschaltungschip zu verwenden, weil Probleme auftreten, die beispielsweise die Notwendigkeit des Führens der Sonde zur Zielposition zur Geräuscherkennung, die Größe des Layoutbereichs und die Größe des Stromverbrauchs betreffen.

Unter den oben erwähnten Umständen ist der Chipaufbau, in dem die Geräuschmessschaltung mit der hochintegrierten Hauptschaltung kombiniert wird, in der bekannten Technologie zur Feststellung der Betriebsstörung in der hochintegrierten Hauptschaltung bekannt, wobei diese Betriebsstörung von einem Ansteigen des Geräuschpegels des Stromversorgungssignals begleitet wird, s. beispielsweise die japanische Patentveröffentlichung JP 2002-222929. Die in dieser Patentveröffentlichung beschriebene Geräuschmessschaltung stellt jedoch den Spannungswert der Stromversorgungsleitung fest, vergleicht den festgestellten Spannungswert mit einem festgelegten Spannungsschwellwert, der vorher in der Schaltung eingestellt wird, und führt das vorbestimmte Verfahren durch, wenn der festgestellte Geräuschpegel größer als der festgelegte Spannungsschwellwert ist, wobei also das bekannte Unterdrückungsverfahren nur auf die Augenblickswerte der Geräuschdaten gerichtet ist. Deshalb können keine Daten, die sich auf temporäre Überspannungsreihen und damit auf die Spannungspegelschwankungen beziehen, und keine Geräuschpegelschwankungen erreicht werden. Bei dieser bekannten Technologie ist es schwierig, eine Betriebsstörungsdiagnose oder eine Fehleranalyse zur Beurteilung durchzuführen, ob ein Fehler durch das Geräusch aufgetreten ist oder nicht und ob die Zeit; in der ein Fehler aufgetreten ist, derjenigen Zeit entspricht, in der das Geräusch aufgetreten ist, oder nicht.

### Zusammenfassung der Erfindung (zu lösendes Problem)

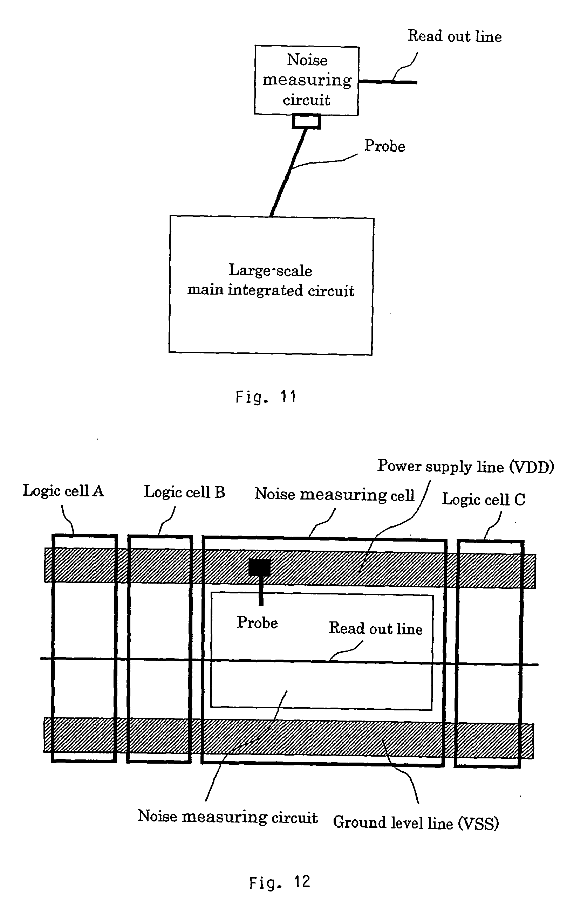

Bei dem in Fig. 11 gezeigten, bekannten Aufbau der integrierten Halbleiterschaltung ist die Geräuschmessschaltung in einer externen Lage angeordnet, die von der hochintegrierten Hauptschaltung (das zu messende Geräusch) getrennt ist, so dass Probleme, die beispielsweise die Notwendigkeit des Zuführens der Sonde zur Zielstelle für die Geräuschfeststellung betreffen, und der Nachteil der Verschlechterung der Feststellungscharakteristik auftreten, wobei diese Verschlechterung aufgrund des Vorhandenseins einer parasitären Kapazität und eines parasitären Widerstands der Zuführader auftritt, die das Ansteigen der Länge der Zuführader im Verhältnis zur Ausdehnung des Layoutbereichs begleitet.

Um die Länge der Zuführungsader zu verkürzen, sollte eine Änderung des Layoutbereichs erfolgen, die aber eine mühsame Aufgabe sein kann. Unter Berücksichtigung des vorher Gesagten besteht daher die erste Aufgabe der vorliegenden Erfindung darin, eine Geräuschmessschaltung zu schaffen, die einen räumlich kleinen Aufbau aufweist, um sie mit der hochintegrierten Hauptschaltung zu kombinieren.

Es gibt noch das weitere Problem, dass es bei der bekannten Geräuschmessschaltung schwierig ist, die von der Stromversorgung und Masse kommenden, temporären Überspannungsgeräusche ausfindig zu machen, weil das Geräusch nur als Augenblickswerte vorliegt. Eine zweite Aufgabe der vorliegenden Erfindung besteht daher darin, eine Geräuschmessschaltung zu schaffen, die die Geräuschwellenformen als analoge Wellenformen in einer Zeitdimension ausfindig macht, die nicht die der Augenblickswerte entspricht, und die die temporären Überspannungsgeräuschschwankungen als Seriendaten des Spannungssignals und des Massesignals oder als analoge Abtastwerte ausgibt.

Zunächst wird eine digitale, hochintegrierte Festkörperschaltung aus Millionen von Transistoren erstellt, wobei die Layoutfläche eine Größe von unter mehreren Quadratmillimetern aufweist; es ist unbedingt erforderlich, die räumliche Verteilung der Stärke des Spannungspegels und Massepegels als wichtigen Schritt zur Analyse der Verschlechterung der hochintegrierten Hauptfestkörperschaltung herauszufinden. Eine dritte Aufgabe der vorliegenden Erfindung besteht darin, eine Geräuschmessschaltung zu schaffen, die die räumlich Verteilung der Geräuschstärke durch Messen des Geräusches an vielen Stellen feststellt, wobei mehrere Geräuschmessschaltungen in der hochintegrierten Hauptfestkörperschaltung kombiniert werden.

Dann ist eine Fehlerfreiheitsprüfung, die sich auf die aktuelle Messung des Geräusches im Spannungs- und Massepegel bezieht, unbedingt erforderlich, wenn eine Simulationssoftware zum Analysieren und Vorhersagen des Geräusches im Spannungs- und Massepegel beim praktischen Systementwurf angewendet wird. Eine vierte Aufgabe besteht darin, eine Geräuschmessschaltung zu schaffen, die die Genauigkeit der Simulationssoftware durch die Durchführung einer Geräuschverteilungsmessung und das Verwenden der gemessenen Geräuschdaten verbessert.

Die integrierte Halbleiterschaltung weist einen Layoutbereich auf, in dem die Zellenhöhe einen konstanten Wert aufweist, die Stromversorgungsleitung und die Masseleitung in einer konstanten Position angeordnet sind und in dem die Grundlogiktorzellen regelmäßig gruppiert sind (der Standardaufbau der Zelltypschaltung). Wie in Fig. 12 gezeigt ist, weist die Geräuschmessschaltung für die Stromversorgungsleitung und die Masseleitung einen Aufbau auf, bei dem die Zellenhöhe der Geräuschmessschaltung genau dieselbe wie die der digitalen Schaltung ist und bei dem die Position der Stromversorgungsleitung und Masseleitung in der digitalen Schaltung in derselben Position wie bei der Standardzelltypschaltung liegt.

Die Geräuschmessschaltung der integrierten Schaltung gemäß der vorliegenden Erfindung wird mittels eines Herstellungsverfahrens gebildet, bei dem CMOS-Halbleiter verwendet werden. Die zur Stromversorgungsleitung (Hochspannungsseite) gehörende Geräuschmessschaltung weist einen mit der Drainelektrode auf Masse gelegten Verstärker (Sourceelektrodenfolger), der mit einem n-Typ-MOSFET oder einem p-Typ-MOSFET gebildet ist, einen selektiven Leseschaltkreis und einem mit der Sourceelektrode auf Masse gelegten Verstärker auf, der mit einem p-Typ-MOSFET gebildet ist. Die zur Stromversorgungsleitung (Niederspannungsseite) gehörende Geräuschmessschaltung weist einen mit der Drainelektrode auf Masse gelegten Verstärker (Sourceelektrodenfolger), der mit einem p-Typ-MOSFET gebildet ist, einen selektiven Leseschaltkreis und einen mit der Sourceelektrode auf Masse gelegten Verstärker auf, der mit einem n-Typ-MOSFET gebildet ist. Diese Geräuschmessschaltung kann mit nur einigen (etwa 6) MOS-Transistoren aufgebaut werden, so dass der Layoutbereich für die Geräuschmessschaltung klein und in derselben Größe wie eine Standardzelltyplogiktorschaltung gehalten werden kann.

Was das Ausgangssignal der Geräuschmessschaltungen betrifft, so wird der Ausgangsstrom des mit der Sourceelektrode auf Masse gelegten Verstärkers zur üblichen Busleitung geführt, der Ausgangsstrom wird mittels einer Spiegelbildschaltung verstärkt, und der verstärkte Strom wird mittels einer externen Widerstandslastschaltung gelesen. Mehrere Geräuschmessschaltungen können parallel mit der üblichen Busleitung verbunden sein, die Geräuschmessschaltung kann durch ein Auswahlsignal selektiv aktiviert werden, und die Geräuschmessung kann an den Vielfachstellen in der hochintegrierten Hauptschaltung durch Ablesen des Ausgangsstroms durchgeführt werden.

Die Geräuschmessschaltung gemäß der vorliegenden Erfindung kann größenmäßig klein aufgebaut und in die hochintegrierte Hauptschaltung eingebettet werden. Deshalb kann die Geräuschmessschaltung gemäß der vorliegenden Erfindung das Geräusch an beliebigen, gewünschten Stellen in der hochintegrierten Hauptschaltung durch Einbetten der Geräuschmessschaltung an gewünschten Stellen im Voraus feststellen und messen. Ferner ist es nicht nötig, eine Sonde zu den gewünschten Stellen zu führen; es gibt keine Verschlechterung der festgestellten Merkmale, und die Geräuschmessschaltung gemäß der vorliegenden Erfindung kann das Geräusch im Stromversorgungssignal und Massepegelsignal leicht auswerten.

Die Geräuschmessschaltung gemäß der vorliegenden Erfindung kann die temporären Überspannungsseriendaten des Stromversorgungssignals und des Massepegelsignals durch Messen der Signalform als analoge Wellenform in einer Zeitdimension, die nicht Augenblickswerte darstellt, und durch Ausgeben der gewonnenen Daten des Stromversorgungs- und Massepegels als analoge Serienwerte oder als analoge Abtastwerte feststellen.

Ferner kann die räumliche Verteilung der Geräuschstärke durch Einbetten mehrerer Geräuschmessschaltungen an den gewünschten Stellen in der hochintegrierten Schaltung und durch Messen des Geräusches an den gewünschten Vielfachstellen festgestellt werden. Die Betriebsstörungsdiagnose und die Fehleranalyse können leicht durch Betrachten der Beziehung zwischen den gewonnenen temporären Seriendaten der Geräuschüberspannung, der räumlichen Stärkeverteilung des Geräuschspannungspegels, der festgestellten Stellen, an denen sich aktuell ein Fehler ereignet hat, und der festgestellten Zeit, in der sich der Fehler ereignet hat, durchgeführt werden.

Ferner kann die Geräuschmessschaltung gemäß der vorliegenden Erfindung parallel zu anderen Standardzellen an gewünschten Stelle für die Geräuschfeststellung in der digitalen, Standardzelltypen enthaltenden, hochintegrierten Schaltung angeordnet werden, so dass die Geräuschmessschaltung der automatischen Layouterstellung durch die auf Standardzellen beruhende Software für die automatische Platz- und Trassenführungswahl zugehört und damit in die hochintegrierte Schaltung als Betriebsstörungsanalysen-Diagnoseschaltung für den praktischen Gebrauch im Voraus eingebettet werden kann.

Neuerdings wird darüber hinaus verlangt, dass der Geräuschpegel des digitalen Substrats in der analog-digitalen Misch-LSI vermindert und die Schwellwertspannung des MOSFET für die digitale, hochintegrierte Schaltung gesteuert wird. Für diesen Zweck weist die hochintegrierte Schaltung eine Stromversorgungsleitung (VVD) und eine Masseleitung (VSS) auf, die beide von der Leitung zur Festlegung des Spannungspegels der Wanne getrennt sind, in dem der MOSFET der hochintegrierten Hauptschaltung angeordnet ist. Die Geräuschmessschaltung gemäß der vorliegenden Erfindung kann zur Feststellung von Geräusch auf jeder Leitung verwendet werden, die einen Bezug zur Stromversorgungsleitung und der Masseleitung in der hochintegrierten Schaltung hat, beispielsweise VVD, VSS, n-wannenbefestigte Stromversorgungsleitung (VDD-n-Wanne) im p-Typ-MOSFET und p-wannenbefestigte Masseleitung (VSS-p-Wanne) im n-Typ-MOSFET.

Nachfolgend werden anhand von entsprechenden Zeichnungen bevorzugte Ausführungen beschrieben.

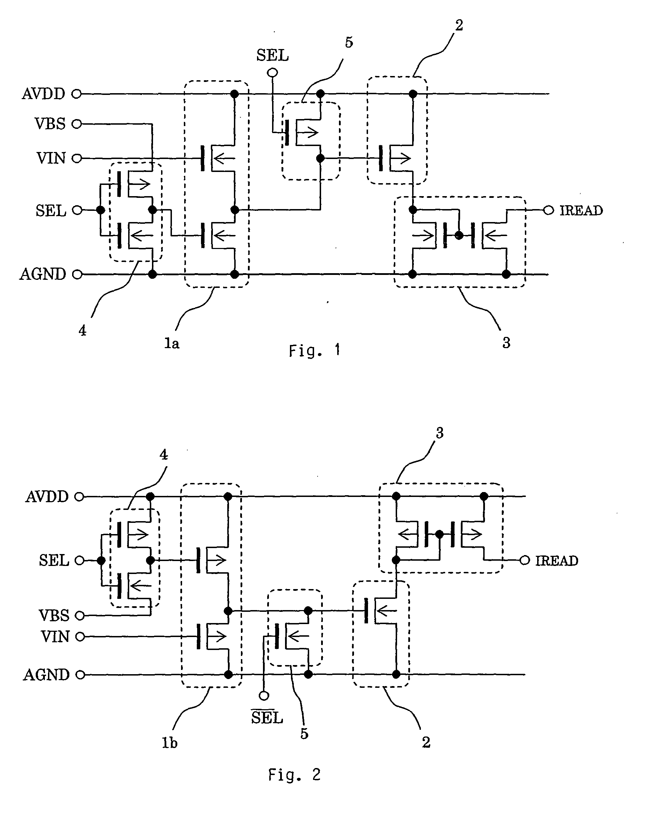

Fig. 1 zeigt eine Schaltungsanordnung einer Stromversorgungsgeräuschmessschaltung gemäß der vorliegenden Erfindung. Die Stromversorgungs-Geräuschmessschaltung gemäß der vorliegenden Erfindung ist an eine integrierte Halbleiterschaltung mit vielen Schaltungsblöcken zur Ausführung der Signalverarbeitung angepasst und weist einen n-Typ-Sourceelektrodenfolger 1a, dessen Eingangsknoten mit der zu messenden Stromversorgungsleitung verbunden ist, eine Signalkonverter-Verstärkerschaltung 2, die das Eingangsspannungssignal in ein Ausgangsstromsignal konvertiert und deren Eingang der Ausgang des Sourceelektrodenfolgers 1a ist, und eine Stromausleseschaltung 3 auf, die den Ausgangsstrom der Verstärkerschaltung 2 ausliest. Ferner zeigt die Fig. 1 weitere Schaltungselemente der Stromversorgungs-Geräuschmessschaltung, eine Inverterschaltung 4, die die Funktion der selektiven Aktivierung der Stromversorgungs-Geräuschmessschaltung hat, und einen Ausschalter 5 zum Schalten der Stromausleseschaltung 3.

Nachfolgend wird die Arbeitsweise der Stromversorgungs-Geräuschmessschaltung der ersten Ausführung gemäß der vorliegenden Erfindung anhand der Fig. 1 beschrieben. Zunächst wird der Mechanismus des Auftretens des Geräusches kurz erläutert. Die Aufgabe der CMOS-Logikschaltung ist, ein logisches Signal durch Ein- und Ausschalten von Elementen, wie den Transistoren in der Schaltung, mittels der Eingangssignale zu erzeugen. In diesem Augenblick wird ein Überstrom von der Stromversorgung aufgrund der Ladung oder Entladung parasitärer Kapazitanzen in der Schaltung geliefert und der Masseleitung zugeführt. Das Geräusch wird dadurch erzeugt, dass der Überstrom durch die Widerstands- oder Impedanzelemente der Stromversorgungsleitungen verläuft.

Um das Geräusch in den Stromversorgungsleitungen festzustellen, wird der eingangsseitige Anschluss des in Fig. 1 gezeigten n-Typ-Sourceelektrodenfolgers 1a (VIN) mit der Stromversorgungsleitung (VDD) der hochintegrierten Hauptschaltung verbunden. Die Stromversorgung (AVDD) für die Geräuschmessschaltung und Masse (AGND) für die Geräuschmessschaltung sind unabhängig von der Leitung installiert, die zur Stromversorgungsleitung (VDD) und zur Masse (VSS) geführt ist, so dass das Geräusch genau gemessen werden kann.

Die in Fig. 1 gezeigte Inverterschaltung 4 weist einen n-Kanal-MOSFET und einen p-Kanal-MOSFET in Reihe auf. Wenn ein Signal "1" dem Auswahlschalter (SEL) der Inverterschaltung zugeführt wird, so besteht das Eingangssignal des Eingangsanschlusses der Inverterschaltung 4 aus einer "0", und der n-Kanal-MOSFET wird gesperrt, und im Gegensatz dazu wird der p-Kanal-MOSFET durchgeschaltet, so dass die Vorspannung (VBS) zur Eingangsgateelektrode des Sourceelektrodenfolgers gelangt und dieser somit in den Aktivzustand versetzt wird.

Wenn das Signal "1" dem Auswahlschalter (SEL) zugeführt wird, schaltet der Schalter 5 zum Schalten der Stromausleseschaltung aus, so dass sowohl die folgende Signalkonverter-Verstärkerschaltung 2, die die Eingangsspannung in einen Ausgangsstrom konvertiert, als auch die Stromausleseschaltung 3 eingeschaltet werden. Deshalb nimmt das Eingangssignal der Signalkonverter-Verstärkerschaltung 2, die die Eingangsspannung in einen Ausgangsstrom konvertiert, den Wert der Ausgangsspannung des Sourceelektrodenfolgers 1a an. Die Spannungsschwankung, die das Stromversorgungsgeräusch verkörpert, wird verstärkt und als Stromschwankung ausgegeben, so dass die Geräuschinformation als analoge Werte am Ausgang der Stromausleseschaltung 3 erscheint. Durch dieses Verfahren werden die temporären Überspannungen des Stromversorgungsgeräusches gewonnen. Die oben beschriebene Stromversorgungsgeräuschmessschaltung verwendet einen n-Typ-Sourceelektrodenfolger in der jüngsten, integrierten Schaltung, wobei viele unterschiedliche Betriebsspannungen aufweisende Transistoren in dieser Schaltung installiert sein können, doch es kann auch ein p-Typ-Sourceelektrodenfolger unter geeigneter Auswahl von VDD und AVDD verwendet werden (AVDD wird mit einer etwas höheren Spannung als VDD gewählt).

Die Fig. 2 zeigt eine Schaltungsanordnung der Massegeräuschmessschaltung gemäß der vorliegenden Erfindung, wobei diese Schaltungsanordnung an eine integrierte Halbleiterschaltung angepasst ist, die viele Schaltungsblöcke zur Ausführung der Signalverarbeitung aufweist. Diese Schaltungsanordnung umfasst einen p-Typ-Sourceelektrodenfolger 1b, der mit seinem Eingangsknoten an die zu messende Masseleitung angeschlossen ist, eine Signalkonverter-Verstärkerschaltung 2, die die Eingangsspannung in einen Ausgangsstrom konvertiert, wobei der Eingang der Ausgang des Sourceelektrodenfolgers ist, und eine Stromausleseschaltung 3 zum Auslesen des Ausgangsstroms der Signalkonverter-Verstärkerschaltung 2. Zusätzlich zeigt die Fig. 2 ähnlich wie die Fig. 1 weitere Schaltungselemente der Massegeräuschmessschaltung, nämlich eine Inverterschaltung 4, die die Funktion der selektiven Aktivierung der Massegeräuschmessschaltung hat, und einen Ausschalter 5 zum Schalten der genannten Stromausleseschaltung 3.

Im Folgenden wird die Arbeitsweise der Massegeräuschmessschaltung beschrieben. Die Grundbetriebsweise ist dieselbe wie bei der Fig. 1 mit Ausnahme der folgenden Merkmale: die Eingangsseite des in Fig. 2 gezeigten p-Typ-Sourceelektrodenfolgers 1b (VIN) ist mit der Masseleitung (VSS) der zu messenden, integrierten Schaltung verbunden; die Polarität des MOSFET ist umgekehrt wie die bei der Fig. 1, und die Arbeitsweise des Auswählsignals ist umgekehrt wie die bei der Fig. 1.

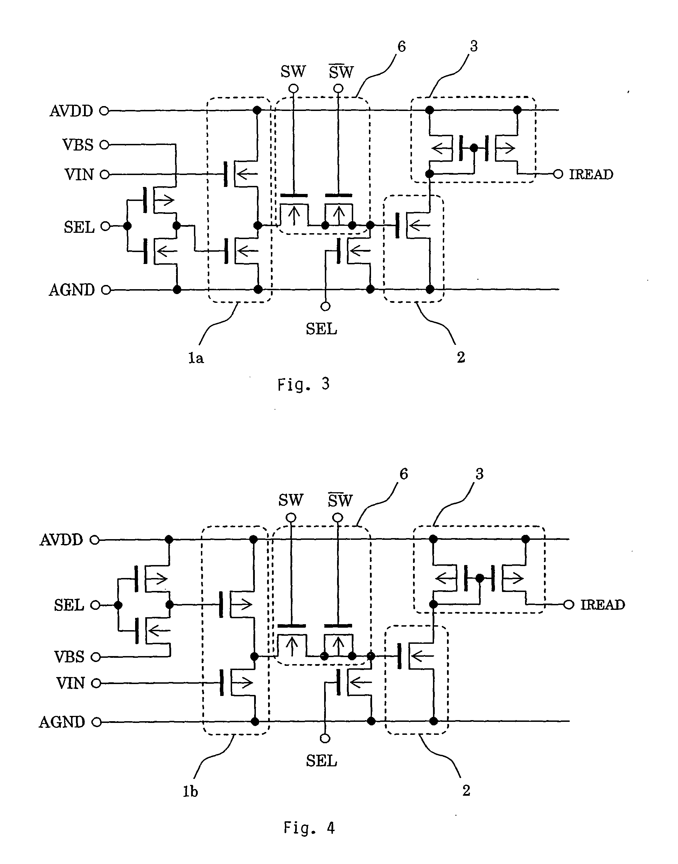

Im Folgenden wird die in Fig. 3 gezeigte Stromversorgungs-Geräuschmessschaltung (mit einem Abtastschalter) gemäß der vorliegenden Erfindung beschrieben. Im Fall der in Fig.1 gezeigten Stromversorgungs-Geräuschmessschaltung wird die Spannungsschwankung der Stromversorgungsleitung der integrierten Schaltung kontinuierlich gewonnen, doch im Fall der in Fig. 3 gezeigten Stromversorgungs-Geräuschmessschaltung ist die Arbeitsweise dieselbe wie bei der in Fig.1 gezeigten Stromversorgungs-Geräuschmessschaltung, wenn der Zustand des Abtastschalters (SW) "1" ist, doch die Stromversorgungs-Geräuschmessschaltung hält den Geräuschaugenblickswert, wenn der Zustand des Abtastschalters (SW) von "1" auf "0" wechselt. Deshalb ist es möglich, die Geräuschwellenform dadurch zu gewinnen, dass das Abtastverfahren verwendet wird, bei dem die Arbeitsweise des Abtastschalters (SW) mit der Arbeitsweise der digitalen Schaltung synchronisiert und das Geräusch durch Verschieben der Minutenzeit Schritt für Schritt gemessen wird.

Die Wirkung der gewonnenen Geräuschwellenform durch das Abtastverfahren wird im Folgenden beschrieben. Beim Messvorgang der in Fig. 1 gezeigten Stromversorgungs-Geräuschmessschaltung mit der kontinuierlichen Messung wird das Geräusch der Ausgangswellenform der Geräuschmessschaltung überlagert, so dass die festgestellte Geräuschwellenform in der ausgelesenen Wellenform unterschiedlich zur Geräuschwellenform sein kann. Durch Anwendung des Abtastverfahrens wird jeder Augenblickswert der Geräuschwellenform als Gleichspannungselement ausgelesen, und damit kann das überlagerte Geräusch eliminiert werden.

Weiterhin ist die Arbeitsweise der in Fig. 4 gezeigten Massegeräuschmessschaltung (mit dem Abtastschalter) die gleiche wie bei der in Fig. 3 gezeigten Massegeräuschmessschaltung. Im Fall der in Fig. 2 gezeigten Massegeräuschmessschaltung wird die Spannungsschwankung auf der Masseleitung für die integrierte Schaltung kontinuierlich gewonnen, doch im Fall der in Fig. 4 gezeigten Massegeräuschmessschaltung hält diese den Geräuschaugenblickswert, wenn der Abtastschalter (SW) seinen Zustand von "1" nach "0" wechselt.

Die in Fig. 3 gezeigte Stromversorgungs-Geräuschmessschaltung und die in Fig. 4 gezeigte Massegeräuschmessschaltung weisen bei der Verwendung des Abtastschalters die folgenden Vorteile auf: der Vorteil bei der Verwendung des Abtastschalters ist der, dass die Polarität des MOSFET in der Stromausleseschaltung 3 in derselben Weise im Schaltungsaufbau zwischen der Stromversorgungs-Geräuschmessschaltung und der Massegeräuschmessschaltung ausgebildet werden kann. Zur Erreichung des oben erwähnten Vorteils ist es nötig, dass die Eingangsgleichspannung der Signalkonverter-Verstärkerschaltung 2 fast die gleiche ist. Um die Eingangsgleichspannung anzugleichen, ist es wichtig, die Spannungsdifferenz zwischen der Stromversorgung für die integrierte Hauptschaltung (VDD) und der Stromversorgung für die Geräuschmessschaltung (AVDD) einzustellen und die Transistorgröße des Sourceelektrodenfolgers (1a, 1b) einzustellen. Durch diese Einstellungen, bei denen die Eingangsgleichspannung der Signalkonverter-Verstärkerschaltung 2 fast angeglichen ist, kann die Ausbildung der Stromausleseschaltung 3 in bekannter Weise erfolgen.

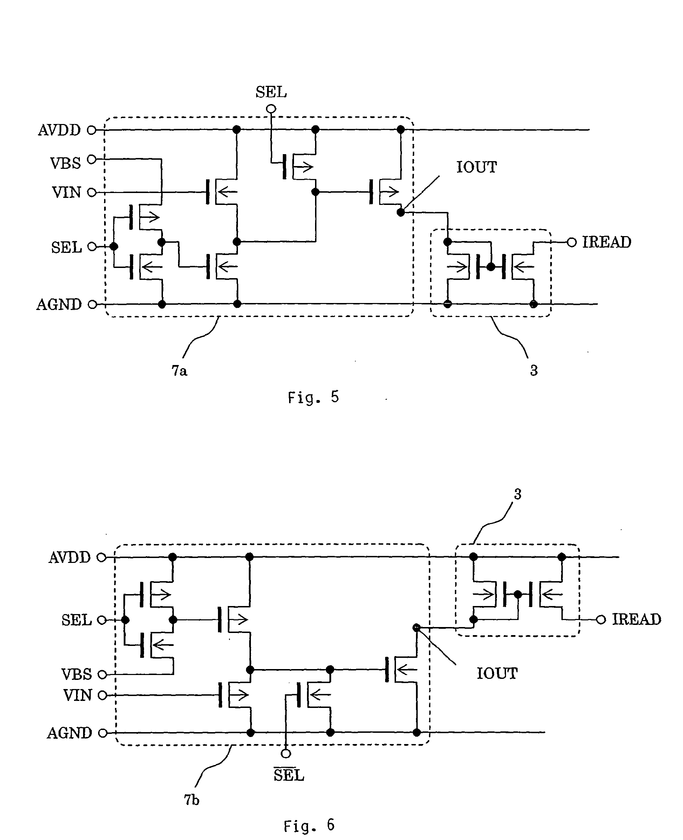

Die Fig. 5 zeigt eine Schaltungsanordnung der Stromversorgungs-Geräuschmessschaltung. In der digitalen, hochintegrierten Schaltung überschreitet deren Layoutfläche mehrere Quadratmillimeter, so dass die räumliche Verteilung der Geräuschstärke für die vorher erwähnte Betriebsstörungsanalyse festgestellt werden sollte. Um diese Verteilung festzustellen, werden viele kleine Stromversorgungs-Geräuschmessschaltungen im gewünschten Teil der integrierten Hauptschaltung eingebettet und angeordnet. Bei dieser Ausführung, bei der der Schaltungsaufbau der Stromversorgungs-Geräuschmessschaltung als Fig. 5 gezeigt ist, ist der Stromausgangsanschluss (IOUT) an die Signalkonverter-Verstärkungsschaltung angeschlossen, und die Stromausleseschaltung 3 als Fig. 5 gezeigt ist, ist der Stromausgangsanschluss (IOUT) an die Signalkonverter-Verstärkungsschaltung angeschlossen, und die Stromausleseschaltung 3 ist für viele davor liegende Vorderabschnitte der Geräuschmessschaltung gemeinsam vorgesehen. Viele n-Typ-Vorderabschnitte 7a der Stromversorgungs-Geräuschmessschaltung sind in der integrierten Schaltung angeordnet und bilden Vielfachmessstellen. Bei diesem Aufbau kann die für mehrere Vorderabschnitte 7a der Geräuschmessschaltung vorgesehene Stromausleseschaltung 3 nur das Signal eines ausgewählten Vorderabschnitts der Geräuschmessschaltung durch Einschalten des Ausschalters der Stromausleseschaltung aller nicht ausgewählten Vorderabschnitte der Geräuschmessschaltung mit Ausnahme des ausgewählten Vorderabschnitts 7a der Geräuschmessschaltung auslesen. Die vielen Vorderabschnitte 7a der Geräuschmessschaltung können jeweils mit nur einigen (etwa 6) MOSFET-Transistoren aufgebaut werden, so das das Layout für die Geräuschmessschaltung klein ausgebildet und die Geräuschmessschaltung leicht in die integrierte Schaltung eingebettet werden kann.

Die Fig. 6 zeigt eine Schaltungsanordnung der Massegeräuschmessschaltung. Ebenso wie in Fig. 5 umfasst der Schaltungsaufbau der in Fig. 6 gezeigten Massegeräuschmessschaltung einen Stromausgangsanschluss (IOUT), der mit der Signalkonverter-Verstärkerschaltung verbunden ist, und eine Stromausleseschaltung 3, die für viele Vorderabschnitte 7b der Massegeräuschmessschaltung gemeinsam vorgesehen ist. Viele p-Typ-Vorderabschnitte 7b der Massegeräuschmessschaltung sind in der integrierten Schaltung zur Durchführung der Vielfachstellen-Geräuschmessung angeordnet. Die vielen Vorderabschnitte 7b der Geräuschmessschaltung können mit einigen (etwa 6) MOSFET-Transistoren aufgebaut werden, so dass das Layout für die Geräuschmessschaltung klein ausgebildet und die Geräuschmessschaltung leicht in die integrierte Schaltung eingebettet werden kann.

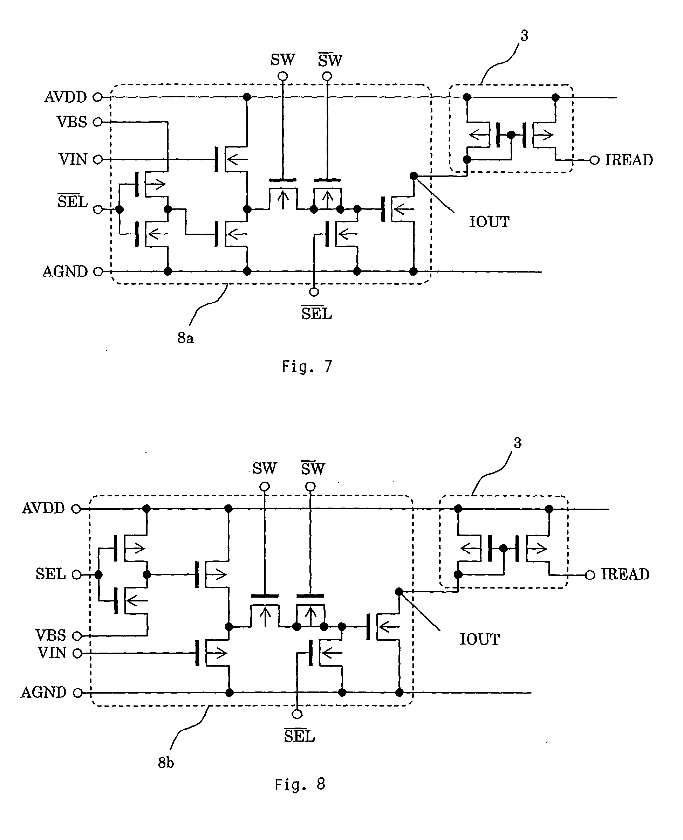

Im Fall der Durchführung der Vielfachstellengeräuschmessung durch die Stromversorgungs-Geräuschmessschaltung nach Fig. 7 und der Massegeräuschmessschaltung (mit dem Abtastschalter) nach Fig. 8 kann eine kompakte Anordnung durch Teilen der Vorderabschnitte (8a, 8b) der Geräuschmessschaltung und der Stromausleseschaltung 3 im Schaltungsaufbau sowie durch gemeinsames Vorsehen der Stromausleseschaltung 3 für viele Vorderabschnitte (8a, 8b) der Geräuschmessschaltung erreicht werden, so dass ein kompaktes Layout für die Stromversorgungs-Geräuschmessschaltung und die Massegeräuschmessschaltung in derselben Größe wie die einer Standardzelltyplogiktorschaltung erreicht werden kann. Wie vorher erwähnt wurde, wird unter Verwendung des Abtastschalters die Polarität des MOSFET in der Stromausleseschaltung 3 zwischen dem Stromversorgungs-Geräuschmessschaltungsaufbau und dem Massegeräuschmessschaltungsaufbau gleich gewählt werden. Deshalb kann die Stromausleseschaltung 3 gemeinsam für die integrierte Hauptschaltung in demjenigen Fall vorgesehen werden, in dem viele kleine Stromversorgungs-Geräuschmessschaltungen und Massegeräuschmessschaltungen im gewünschten Teil der integrierten Hauptschaltung eingebettet und angeordnet werden.

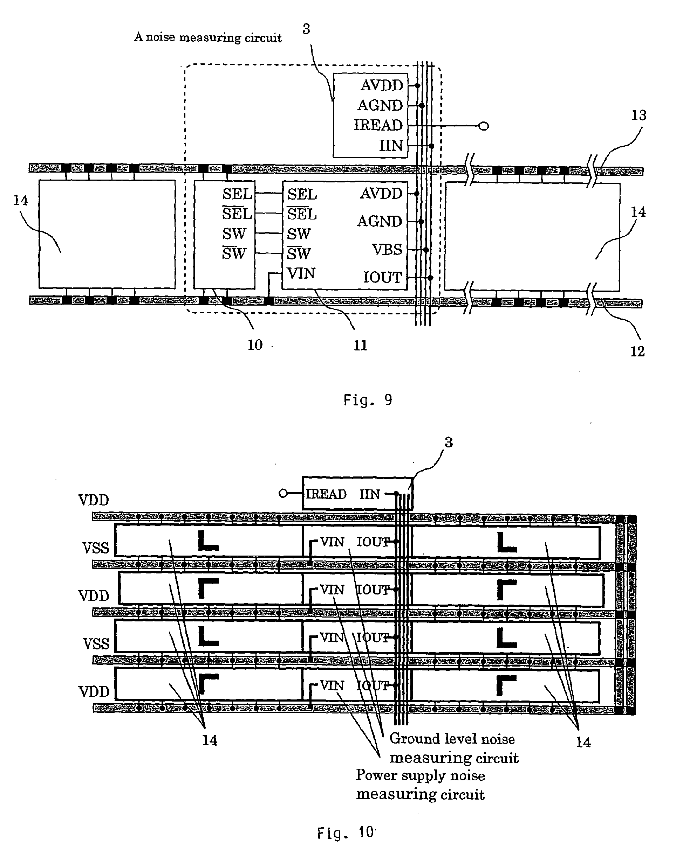

Der ganze Aufbau der Vielfachstellen-Geräuschmessschaltung ist in Fig. 9 dargestellt. Die Geräuschmessschaltung weist die Stromausleseschaltung 3, eine ein Auswählsignal erzeugende, digitale Schaltung 10 und einen Vorderabschnitt 11 der Geräuschmessschaltung auf. Die Stromausleseschaltung 3 ist für viele Vorderabschnitte der Geräuschmessschaltungen gemeinsam vorgesehen, wie es bereits erwähnt wurde. Wenn die zu messende Eingangsanschlussspannung (VIN) der Stromversorgungsleitung (VDD) zugeführt wird, werden die vielen eingebetteten Vorderabschnitte zur Stromversorgungs-Geräuschmessschaltung. Wenn andererseits die zu messende Eingangsanschlussspannung (VIN) der Masseleitung (VSS) zugeführt wird, werden die vielen eingebetteten Vorderabschnitte zur Massegeräuschmessschaltung. Die Stromversorgungsspannung (AVDD) für die Geräuschmessschaltung, die Massespannung (AGND) für die Geräuschmessschaltung und die Vorspannung (VBS) sind auf einer gemeinsamen Leitung vorhanden, zu der alle Geräuschmessschaltungen Zugriff haben. Ebenso ist der Stromausgang (IOUT) der Signalkonverter-Verstärkerschaltung mit der gemeinsamen Busleitung verbunden, zu der alle Geräuschmessschaltungen Zugriff haben.

Wie in Fig. 9 gezeigt ist, ist die Anzahl der Außenanschlüsse der Geräuschmessschaltung gemäß der vorliegenden Erfindung gleich oder geringer als 4 (AVDD, AGND, VBS, IREAD). Der Grund, warum diese Anschlussanzahl gleich oder geringer als 4 ist, ist der, dass im Fall der Verwendung von VSS für die integrierte Hauptschaltung als AGND die erforderliche Zahl der Außenanschlüsse drei ist. Um jedoch das Stromversorgungsgeräusch und Massegeräusch der integrierten Hauptschaltung zu messen, wird vorgezogen, die Stromversorgung und die Masse für die integrierte Hauptschaltung von der Stromversorgung und der Masse für die Geräuschmessschaltung zu trennen. Die Anzahl der Anschlüsse ist wie die Auswerteparameter für die Kosten der integrierten Halbleiterschaltung wichtig. Die Tatsache, dass die Geräuschmessfunktion gemäß der vorliegenden Erfindung durch Zufügen von 4 Anschlüssen installiert werden kann, zeigt, dass es keine Probleme beim praktischen Gebrauch gibt.

Wie in Fig. 9 auch gezeigt ist, kann durch das unabhängige Einbetten des das Auswählsignal erzeugenden, digitalen Teils 10 der Arbeitszeitpunkt der Inverterschaltung für das Auswählsignal und der Arbeitszeitpunkt des Abtastschalters durch die digitale Logikschaltung gesteuert werden. Die geschützten Außenanschlüsse SW und SEL können weggelassen werden, wenn die Logikschaltung zur Steuerung des Geräuschmessteils und des Geräuschmesszeitpunkts in den das Auswählsignal erzeugenden, digitalen Steuerschaltungsteil 10 eingebettet und der das Steuersignal erzeugende Vorgang in der Steuerung des Prüfartvorgangs des digitalen Teils in der integrierten Hauptschaltung durchgeführt wird. Mit anderen Worten kann die eingebaute Selbstprüfung dadurch gebildet werden, dass die Operationslogik des Auswahlzeitpunkts und des Abtastzeitpunkts, die mit dem in die digitale, integrierte Schaltung im Voraus eingebauten Prüfmuster synchronisiert sind, erzeugt wird, dass das Auswählsignal entsprechend der Operationslogik erzeugt wird und dass die Auswahllogik mit der Prüfmusterlogik der im Prüfbetrieb betriebenen, integrierten Hauptschaltung korreliert wird.

Eine Schaltungsanordnung der digitalen, integrierten Schaltung, die in die Vielfachstellen-Geräuschmessschaltung eingebettet ist, ist in Fig. 10 gezeigt. In der hochintegrierten Schaltung nach Fig. 10 wird der größte Teil der Layoutfläche von den digitalen, integrierten Schaltungen 14 beansprucht, wobei die Höhe der Zellen konstant ist und die Stromversorgungsleitung und die Masseleitung in konstanten Positionen angeordnet sind. Die Stromversorgungsleitung (VDD) für die integrierte Hauptschaltung und die Masseleitung (VSS) sind abwechselnd angeordnet. Daher sind, wie in Fig. 10 gezeigt ist, die Stromversorgungsleitung für die Geräuschmessschaltung (die n-Typ-Geräuschmessschaltung) und die Masseleitung für die Geräuschmessschaltung (die p-Typ-Geräuschmessschaltung) abwechselnd angeordnet.

Weiterhin ist bzw. sind in der digitalen, integrierten Schaltung, in der die Vielfachstellen-Geräuschmessschaltungen eingebettet sind, ein Eingangsanschluss bzw. einige Eingangsanschlüsse der Geräuschmessschaltung an die Außenseite angeschlossen, und das bekannte Signal wird dem Anschluss bzw. den Anschlüssen zugeführt und festgestellt. Die Amplitudenwerte der gemessenen Geräuschwellenform können durch Auswerten der Kennzeichen (Empfindlichkeit, Verstärkungsgrad usw.) der in die integrierte Hauptschaltung eingebetteten Geräuschmessschaltung eingestellt werden.

Die Analysemodellauswertung, beispielsweise das Stromversorgungsstromanalysemodell für das CAD-Werkzeug zur Bildung der integrierten Halbleiterschaltungen, kann dadurch ausgeführt werden, dass die aktuell gemessenen Geräuschdaten des gemessenen Schaltungsteils verwendet werden, in dem die Geräuschmessschaltungen gemäß der vorliegenden Erfindung eingebettet sind. Beispielsweise werden einige in der Simulationssoftware vorhandene Analysemodelle dadurch ausgewertet, dass die aktuell gemessenen Geräuschdaten verwendet werden, so dass ein optimales Modell für die Festlegung der nächsten und folgenden integrierten Schaltung in geeigneter Weise gewählt werden kann.

Ferner weist die Impedanz der Stromversorgungsleitungen und der Masseleitungen frequenzabhängige Charakteristiken auf, wobei die Geräuschanalyse durch Betrachten des geeigneten Werts durchgeführt werden sollte, der der Taktfrequenz entspricht. Deshalb wird die Parametereinstellung, beispielsweise die Einstellung des Impedanzkoeffizienten, auf der Grundlage der Geräuschwellenformen durchgeführt, die von der Geräuschmessschaltung gemäß der vorliegenden Erfindung gewonnen wird, und deshalb wird die Simulationsgenauigkeit verbessert.

Die Betriebsstörungsdiagnose, die Fehleranalyse, die Betriebsstörungsvorhersage und die Fehlervorhersage können dadurch durchgeführt werden, dass die aktuell gemessenen Geräuschdaten der zu messenden Teile der integrierten Hauptschaltung verwendet werden, in denen die Geräuschmessschaltungen gemäß der vorliegenden Erfindung eingebettet sind. Die räumliche Verteilung der Geräuschstärke und die temporären Geräuschüberspannungsdaten können unter Zugrundelegung der analogen Werte des ausgelesenen Stroms (IREAD) festgestellt werden, wobei diese Werte Ausgangsdaten der Stromausleseschaltung der Geräuschmessschaltung sind. Deshalb können die Betriebsstörungsanalyse und die Fehleranalyse auf der Grundlage einer Auswertung des Verhältnisses zwischen dem aktuellen Geräusch, der räumlichen Verteilung der Geräuschstärke und den temporären Überspannungsdaten durch Ermittlung der Position und des Zeitpunkts der Betriebsstörung und des Fehlers durchgeführt werden. Ferner wird erwartet, dass die Betriebsstörungsvorhersage und die Fehlervorhersage für neu zu entwickelnde Produkte aufgrund der Grundlage von Daten möglich sind, in denen die Analysedaten und die aktuell gemessenen Geräuschdaten in der Stromversorgung und im Massepegel gespeichert sind, die beide durch den Schaltungsentwurfstyp klassifiziert sind.

In Bezug auf das Anordnen der Geräuschmessschaltung gemäß der vorliegenden Erfindung kann die Geräuschmessschaltung in den zu messenden Teil der integrierten Hauptschaltung automatisch eingebettet werden, wobei das automatische Layoutverfahren für die Standardzellen zur gleichen Zeit verwendet wird, in der die digitale, integrierte Hauptschaltung aufgebaut wird. Wie in Fig. 12 gezeigt ist, kann die Geräuschmessschaltung gemäß der vorliegenden Erfindung parallel zu anderen Standardzellen an gewünschten Stellen zur Geräuscherkennung in der Standardzelltypen aufweisenden, digitalen, hochintegrierten Schaltung angeordnet werden, so dass die Geräuschmessschaltung dem automatischen Layoutentwurf durch die auf Standardzellen basierende, automatische Verdrahtungslayoutentwurfssoftware entspricht. Aufgrund des automatischen Layouts können die Entwicklungskosten vermindert werden, und die Geräuschmessschaltung gemäß der vorliegenden Erfindung kann in die hochintegrierte Schaltung als Betriebsstörungsanalyse- und -diagnoseschaltung für den praktischen Gebrauch im Voraus eingebettet werden, wodurch die Handhabung erleichtert wird. Was die Positionierung der Geräuschmessschaltung betrifft, so kann diese optimal dann erreicht werden, wenn sie auf den Verteilungsdaten einer logischen Aktivierungsgeschwindigkeit beruht.

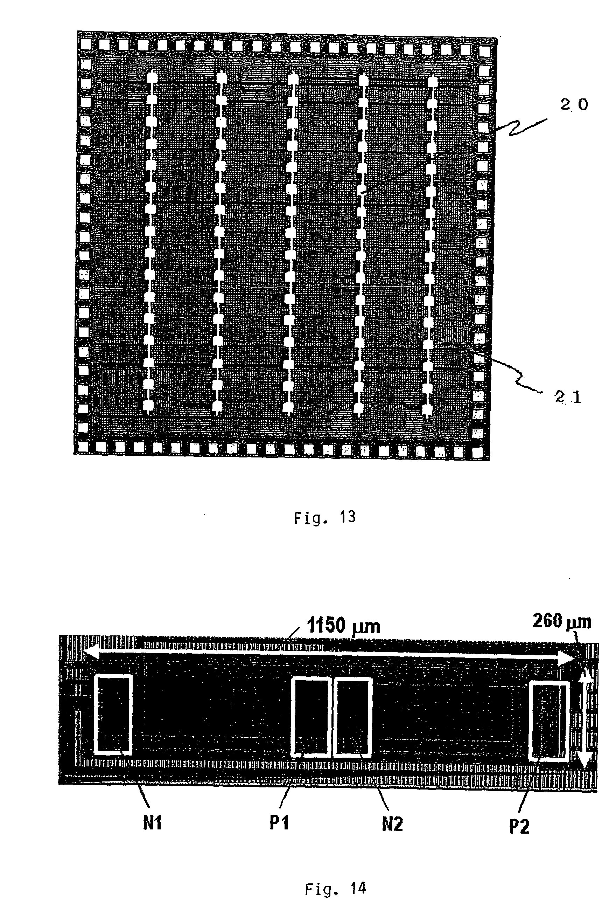

Der Aspekt der eingebetteten Verteilungsanordnung der Stromversorgungs-Geräuschmessschaltung und der Massepegel-Geräuschmessschaltung in der integrierten Hauptschaltung ist in Fig. 13 gezeigt. Durch die eingebettete Verteilungsanordnung der Stromversorgungs-Geräuschmessschaltung und der Massepegel-Geräuschmessschaltung in der integrierten Hauptschaltung können die Stromversorgungs-Geräuschwellenform, die Massepegel-Geräuschwellenform und die Raumverteilungsdaten gewonnen werden, wobei diese Daten erzeugt werden, wenn die integrierte Hauptschaltung betrieben wird. Eine Vergrößerung eines beispielhaften Chips der integrierten Halbleiterschaltung, in der die Geräuschmessschaltungen praktisch eingebettet sind, ist in Fig. 14 gezeigt.

Zwecks Verminderung des Geräuschpegels des digitalen Substrats in der analog-digitalen Misch-LSI und zwecks Steuerung der Schwellwertspannung des MOSFET für die digitale, hochintegrierte Schaltung stellen die Geräuschmessschaltungen (P1, P2, N1, N2) das Geräusch in der n-wannenbefestigten Stromversorgungsleitung des p-Typ-MOSFET und in der p-wannenbefestigten Masseleitung des n-Typ-MOSFET durch Einbetten dieser Geräuschmessschaltungen (P1, P2, N1, N2) in der hochintegrierten Schaltung fest, in der die Stromversorgungsleitung und die Masseleitung von der Leitung zur Festlegung des Spannungspegels der Wanne getrennt sind, an der der MOSFET für die hochintegrierte Hauptschaltung installiert ist.

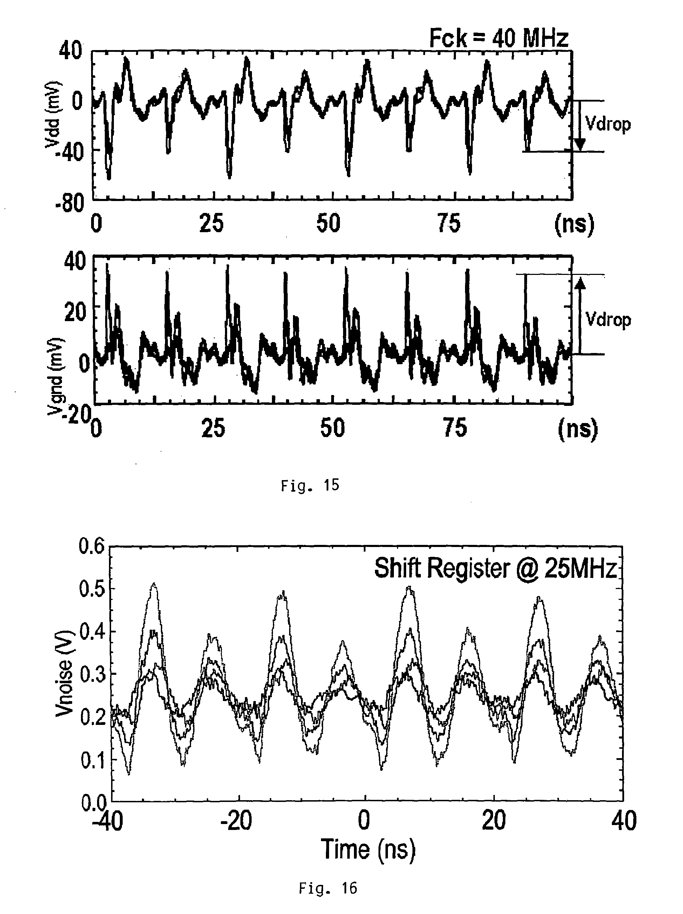

Die Fig. 15 zeigt ein Beispiel der aktuell gemessenen Geräuschwellenform, die von der Stromversorgungs-Geräuschmessschaltung und der Massepegel-Geräuschmessschaltung gemäß der vorliegenden Erfindung gemessen wird. Bei diesem Beispiel wird die Wellenform der Spannungsschwankung einer beliebigen Position in einer konstanten Zeitperiode der integrierten Hauptshaltung von der Geräuschmessschaltung ohne den Abtastschalter gemessen. Die aktuell gemessene Wellenform in Fig. 15 gibt wieder, dass die Spannung der Stromversorgungsleitung und der Masseleitung der integrierten Hauptschaltung nicht statisch, sondern unter dem Geräuscheinfluss dynamisch schwankt.

Die Fig. 16 zeigt die Wellenform (auf der Stromversorgungsseite), die von der Stromversorgungs-Geräuschmessschaltung gemäß der vorliegenden Erfindung im Fall der Vergrößerung der Anzahl der Widerstandsschaltungen gemessen wird, die mit der Geräuschmessschaltung synchron betrieben werden. Die Anzahl der Logikschaltungen der in Fig. 16 gezeigten, integrierten Hauptschaltungen ist 8, 4, 2, 1 in der Reihenfolge der Spitzenhöhe im Geräuschwellenformdiagramm. Die Fig. 16 zeigt, dass, je größer die Anzahl der Logikschaltungen ist, desto größer die Wellenformspitze ist.

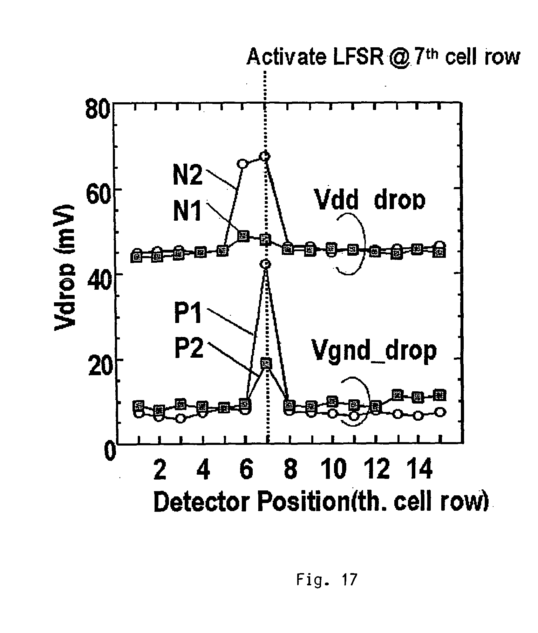

Die Fig. 17 zeigt ein Diagramm der räumlichen Verteilung des Stromversorgungsgeräusches und des Massepegelgeräusches im Chip der integrierten Halbleiterschaltung, in der die in Fig. 14 gezeigten Geräuschmessschaltungen (P1, P2, N1, N2) eingebettet sind. Die Horizontalachse der Fig. 17 stellt die Position der Geräuschmessschaltung in der Zellreihenfolge dar, und P1, P2, N1, N2 bezeichnen den peripheren Teil (N1, P2) und den Mittelteil (P1, N2) der integrierten Hauptschaltung. Die Vertikalachse der Fig.17 stellt den Spannungsbereich des Massepegels (0,0 V) bis zur Stromversorgungsspannung (1,8 V) dar. Wenn in Fig. 17 das in der siebten Zelle positionierte, lineare 32-Bit-Rückkopplungsschieberegister betrieben wird, stellt die Geräuschmessschaltung im Mittelteil der siebten Zelle die größte Spannungsschwankung fest. Gemäß der Fig. 17 ist es möglich, die räumliche Verteilung des Stromversorgungsgeräusches und des Massepegelgeräusches bei Verwendung der vorliegenden Erfindung festzustellen.

Die Geräuschmessschaltung gemäß der vorliegenden Erfindung ist gegenüber den bekannten Geräuschmessschaltungen unterschiedlich und ist kein beanspruchter Prüfchipaufbau. Der Bereich der Geräuschmessschaltung ist klein, und die Anzahl der Anschlüsse der Geräuschmessschaltung ist ebenfalls klein. Deshalb kann die Geräuschmessschaltung als eingebetteter Schaltungstyp und als Betriebsstörungsanalyse- und -diagnoseschaltung für die integrierte Hauptschaltung verwendet werden.

### Kurzbeschreibung der Zeichnungen

Es zeigen:
- Fig. 1: eine Schaltungsanordnung einer Stromversorgungs-Geräuschmessschaltung,
- Fig. 2: eine Schaltungsanordnung einer Massepegel-Geräuschmessschaltung,
- Fig. 3: eine Schaltungsanordnung einer Stromversorgungs-Geräuschmessschaltung mit einem Abtastschalter,
- Fig. 4: eine Schaltungsanordnung einer Massepegel-Geräuschmessschaltung mit einem Abtastschalter,
- Fig. 5: eine Schaltungsanordnung einer Stromversorgungs-Geräuschmessschaltung,
- Fig. 6: eine Schaltungsanordnung einer Massepegel-Geräuschmessschaltung,
- Fig. 7: eine Schaltungsanordnung einer Stromversorgungs-Geräuschmessschaltung mit einem Abtastschalter,
- Fig. 8: eine Schaltungsanordnung einer Massepegel-Geräuschmessschaltung mit einem Abtastschalter,
- Fig. 9: den ganzen Aufbau einer Vielfachstellen-Geräuschmessschaltung,
- Fig. 10: eine bildliche Darstellung einer digitalen, integrierten Schaltung, in die eine Vielfachgeräuschmessschaltung eingebettet ist,
- Figuren 11 und 12: Schaltungsanordnungen einer digitalen, hochintegrierten Schaltung, in die eine Stromversorgungs-Geräuschmessschaltung und eine Massepegel-Geräuschmessschaltung eingebettet sind,
- Fig. 13: eine Schaltungsanordnung, die einen Aspekt einer eingebetteten Verteilungsanordnung der Stromversorgungs-Geräuschmessschaltung und der Massepegel-Geräuschmessschaltung in der integrierten Hauptschaltung wiedergibt,
- Fig. 14: eine vergrößerte Darstellung eines beispielhaften Chips einer integrierten Halbleiterschaltung, in der Geräuschmessschaltungen eingebettet sind,
- Fig. 15: ein Beispiel von aktuell gemessenen Geräuschwellenformen, die von der Stromversorgungs-Geräuschmessschaltung und der MassepegelGeräuschmessschaltung gemäß der vorliegenden Erfindung gemessen werden,
- Fig. 16: eine Wellenform, die von der Stromversorgungs-Geräuschmessschaltung gemäß der vorliegenden Erfindung für den Fall der Vergrößerung der Anzahl von Widerstandsschaltungen aktuell gemessen werden, die synchron mit der Geräuschmessschaltung betrieben werden, und
- Fig. 17: eine Darstellung der räumlichen Verteilung des Stromversorgungsgeräusches und des Massepegelgeräusches im Chip der integrierten Halbleiterschaltung.

### Bezugszeichenliste

- 1a: n-Typ-Sourceelektrodenfolger
- 1b: p-Typ-Sourceelektrodenfolger
- 2: Spannungs-Strom-Signal-Konverter- und Verstärkerschaltung
- 3: Stromausleseschaltung
- 4: Auswählsignal-Inverterschaltung
- 5: Ausschalter zum Steuern der Stromausleseschaltung
- 6: Abtastschalter
- 7a: n-Typ-Vorderabschnitt der Geräuschmessschaltung
- 7b: p-Typ-Vorderabschnitt der Geräuschmessschaltung
- 8a: n-Typ-Vorderabschnitt der Geräuschmessschaltung mit einem Abtastschalter
- 8b: p-Typ-Vorderabschnitt der Geräuschmessschaltung mit einem Abtastschalter
- 11: ein das Auswählsignal erzeugender, digitaler Schaltungsteil
- 12: Vorderabschnitt der Geräuschmessschaltung
- 13: Grundlinie für das zu messende Geräusch (VSS)
- 14: Stromversorgungsleitung für das zu messende Geräusch (VDD)
- 15: digitale, integrierte Hauptschaltung
- 20: Geräuschmessschaltung
- 21: Schaltung für die zu messende Geräuschmessschaltung
- AVDD: Stromversorgung für die Geräuschmessschaltung
- AGND: Masse für die Geräuschmessschaltung
- VBS: Vorspannung
- VIN: zu messende Eingangsspannung
- SEL: Auswählschalter
- IREAD: Auslesestrom
- SW: Abtastschalter
- IOUT: Ausgangsstrom der Signalkonverter- und Verstärkerschaltung
- VDD: Stromversorgung der integrierten Hauptschaltung
- VSS: Masse der integrierten Hauptschaltung
- Ddrop: Spannungsabfallwert der Stromversorgung
- P1: Anordnung 1 einer p-wannenbefestigten Masseleitung der Geräuschmessschaltung
- P2: Anordnung 2 einer p-wannenbefestigten Masseleitung der Geräuschmessschaltung
- N1: Anordnung 1 einer n-wannenbefestigten Masseleitung der Geräuschmessschaltung
- N2: Anordnung 2 einer n-wannenbefestigten Masseleitung der Geräuschmessschaltung
- LFSR: lineares 32-Bit-Rückkopplungsschieberegister

## Patentansprüche

1. Integrierte Halbleiterschaltung mit einer Vielzahl von Schaltungsblöcken, die eine digitale Signalverarbeitung ausführt,
**dadurch gekennzeichnet,**
**dass** Geräuschmessschaltungen in verteilten Anordnungspositionen in der integrierten Halbleiterschaltung eingebettet sind und dass eine Stromversorgungsgeräuschwellenform, eine Messepegelgeräuschwellenform und eine räumliche Verteilung der auftretenden Geräuschpositionen festgestellt werden.

2. Integrierte Halbleiterschaltung nach Anspruch 1,
**dadurch gekennzeichnet,**
**dass** die Geräuschmessschaltung Folgendes aufweist.
- einen Sourceelektrodenfolger, der eine Stromversorgungsleitung der integrierten Halbleiterschaltung mit einem Eingangsknoten der Geräuschmessschaltung verbindet,
- eine Signalkonverter- und Verstärkerschaltung, die die Eingangsspannung in einen Ausgangsstrom konvertiert, wobei der Eingang ein Ausgang des Sourceelektrodenfolgers ist, und
- eine Stromausleseschaltung zum Auslesen eines Ausgangsstroms der Signalkonverter- und Verstärkerschaltung.

3. Integrierte Halbleiterschaltung nach Anspruch 1,
**dadurch gekennzeichnet,**
**dass** die Geräuschmessschaltung Folgendes aufweist:
- einen p-Typ-Sourceelektrodenfolger, der eine Masseleitung der integrierten Schaltung mit einem Eingangsknoten der Geräuschmessschaltung verbindet,
- eine Signalkonverter- und Verstärkerschaltung, die die Eingangsspannung in einen Ausgangsstrom konvertiert, wobei der Eingang einen Ausgang des Sourceelektrodenfolgers bildet, und
- eine Stromausleseschaltung zum Auslesen eines Ausgangsstroms der Signalkonverter- und Verstärkerschaltung.

4. Integrierte Halbleiterschaltung nach Anspruch 1,
**dadurch gekennzeichnet,**
**dass** die Geräuschmessschaltung eine Auswählschaltung aufweist, die zur selektiven Aktivierung der Geräuschmessschaltung dient.

5. Integrierte Halbleiterschaltung nach Anspruch 2 oder 3,
**dadurch gekennzeichnet,**
**dass** die Geräuschmessschaltung ferner einen Abtastschalter aufweist, der mit einem Ausgangsknoten des Sourceelektrodenfolgers verbunden ist.

6. Integrierte Halbleiterschaltung nach Anspruch 2 oder 3,
**dadurch gekennzeichnet,**
**dass** die Stromausleseschaltung jeder der Geräuschmessschaltungen gemeinsam verwendet wird.

7. Diagnose- und Analyseverfahren für eine integrierte Halbleiterschaltung,
**dadurch gekennzeichnet,**
**dass** eine Betriebsstörungsdiagnose, eine Fehleranalyse, eine Betriebsstörungsvorhersage und eine Fehlervorhersage der integrierten Halbleiterschaltung aufgrund von aktuellen Geräuschdaten durchgeführt werden, die aus der integrierten Halbleiterschaltung gewonnen werden, in der die Geräuschmessschaltungen eingebettet sind.

8. Herstellungsverfahren für eine integrierte Halbleiterschaltung für ein sequenzielles Verfahren für ein Entwurfsverfahren, ein Herstellungsverfahren und ein Prüfverfahren (Auswerteverfahren) für die integrierte Halbleiterschaltung,
**dadurch gekennzeichnet,**
**dass** das Herstellungsverfahren den Schritt zum Einbetten der Geräuschmessschaltungen in einer Anordnung mit verteilten Positionen in der integrierten Halbleiterschaltung und das Prüfverfahren den Schritt zur Messung und Auswertung der Stromversorgungs-Geräuschwellenform, der Massepegel-Geräuschwellenform und der Daten einer räumlichen Verteilung durch die Geräuschmessschaltung aufweist.

9. Herstellungsverfahren nach Anspruch 8,
**dadurch gekennzeichnet,**
**dass** der Schritt zur Einbettung der Geräuschmessschaltungen in eine Anordnung mit verteilten Positionen ein automatisches Einbetten in die Positionen der integrierten Schaltung durch Anwenden des für die Standardzellen vorgesehenen, automatischen Verdrahtungslayoutentwurfsverfahrens umfasst.

10. Herstellungsverfahren nach Anspruch 8,
**dadurch gekennzeichnet,**
**dass** bei dem Prüfverfahren eine eingebaute Selbstprüfung vorgesehen ist, die durch Korrelierung einer Auswähllogik der Geräuschmessschaltung mit einer Prüfartlogik (Prüfmuster) der integrierten Schaltung durchgeführt wird.

11. Auswerte- und Einstellungsverfahren eines Entwurfs-CAD-Werkzeugs für integrierte Halbleiterschaltungen,
**dadurch gekennzeichnet,**
**dass** eine Analysemodellauswertung, vorzugsweise ein Stromversorgungs-Stromanalysenmodell, für das Entwurfs-CAD-Werkzeug für die integrierte Halbleiterschaltung oder eine Parametereinstellung, vorzugsweise ein Impedanzkoeffizient, auf der Grundlage von aktuell gemessenen Geräuschdaten der Position der gemessenen, integrierten Schaltung durchgeführt wird, in der die Geräuschmessschaltungen der integrierten Halbleiterschaltung gemäß Anspruch 1 eingebettet sind.
